(19) Europäisches Patentamt

European Patent Office

Office européen des brevets

(11) **EP 1 672 860 A1**

(12) **EUROPEAN PATENT APPLICATION**
published in accordance with Art. 158(3) EPC

(43) Date of publication:
**21.06.2006 Bulletin 2006/25**

(51) Int Cl.:
*H04L 27/36* (1990.01)    *H04L 27/20* (1968.09)

(21) Application number: **04792778.5**

(22) Date of filing: **21.10.2004**

(86) International application number:
**PCT/JP2004/015629**

(87) International publication number:
**WO 2005/039136 (28.04.2005 Gazette 2005/17)**

(84) Designated Contracting States:
**DE FR GB**

(30) Priority: **22.10.2003 JP 2003362393**
**20.10.2004 JP 2004305807**

(71) Applicant: **MATSUSHITA ELECTRIC INDUSTRIAL CO., LTD.**
**Kadoma-shi, Osaka 571-8501 (JP)**

(72) Inventors:
• **SATO, Junji,**
**Electric Industrial Co., Ltd.**
**1-3-7 Shiromi, Chuo-ku,**
**Osaka 540-6319 (JP)**

• **MATSUO, Michiaki,**
**Electric Industrial Co., Ltd.**
**1-3-7 Shiromi, Chuo-ku,**
**Osaka 540-6319 (JP)**

• **SAITO, Noriaki,**
**Electric Industrial Co., Ltd.**
**1-3-7 Shiromi, Chuo-ku,**
**Osaka 540-6319 (JP)**

• **SHIMIZU, Yoshito,**
**Electric Industrial Co., Ltd.**
**1-3-7 Shiromi, Chuo-ku,**
**Osaka 540-6319 (JP)**

(74) Representative: **Grünecker, Kinkeldey,**
**Stockmair & Schwanhäusser**
**Anwaltssozietät**
**Maximilianstrasse 58**
**80538 München (DE)**

(54) **MODULATING APPARATUS AND MODULATING METHOD**

(57)    A modulation apparatus which can be applied to the conventional analog PLL modulation system without using an enormous reference table, enables a phase distortion to be compensated accurately without requiring timing control with high accuracy, and can be applied to communication systems that do not perform amplitude modulation. In this apparatus, a signal generation section (101) generates a baseband phase signal. A phase distortion compensation section (102) obtains a phase distortion by multiplying a magnitude of a frequency change at predetermined time or magnitude of phase change between adjacent data of the baseband phase signal by a parameter specific to the apparatus, and thereby compensates the baseband phase signal for the phase distortion. A storage section (103) stores the parameter and calculation equation. A modulation section (105) modulates a frequency converted signal input from a frequency conversion section (104) using the baseband phase signal to generate a modulated signal.

FIG.4

**Description**

Technical Field

The present invention relates to a modulation apparatus and modulation method, and more particularly, to a modulation apparatus and modulation method for compensating a phase distortion to a baseband signal.

Background Art

In recent years, mobile communication systems employs various modulation and demodulation systems, and a polar coordinate modulation system is known as a modulation system expected to achieve power savings in wireless terminals and high efficiency. In the polar coordinate modulation system, a modulation bandwidth is spread more than four times wider than a symbol rate of a transmission baseband signal when the transmission baseband signal is separated into an amplitude component and phase component. Therefore, using an analog PLL modulation system that is the most widely used in the current GSM system in a phase modulation section of the polar coordinate modulation system results in lack of a PLL bandwidth, which causes a phase distortion to occur in an output of a modulator and distorting the frequency spectrum.

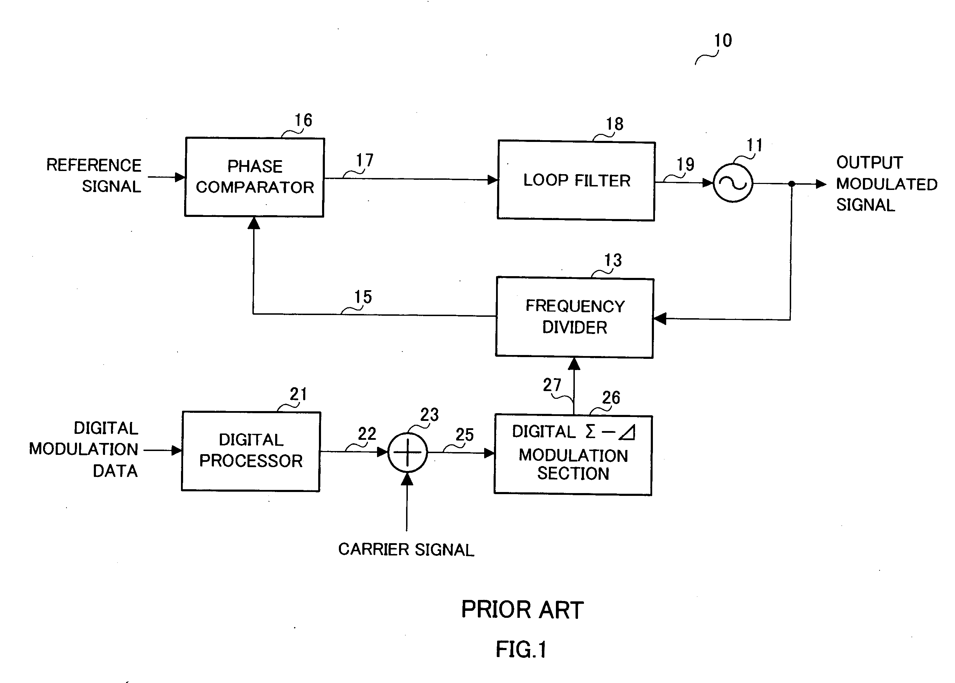

For this issue, a technique is proposed for compensating a transmission baseband signal to apparently expand the PLL bandwidth, and thereby improving characteristics of a PLL modulator (for example, see Patent Document 1) . FIG. 1 shows a schematic block diagram of a conventional PLL modulation apparatus that improves a loop bandwidth. In FIG. 1, "10" denotes a PLL modulation apparatus, "11" denotes a voltage control oscillator (hereinafter, referred to as a "VCO"), "13" denotes a frequency divider, "15" denotes a divided carrier signal, "16" denotes a phase comparator that compares a phase of a reference signal and a phase of the divided carrier signal 15, "17" denotes a control signal output fromphase comparator 16, "18" denotes a loop filter that smoothes an distortion signal, "19" denotes a smoothed control signal, "21" denotes a digital processor that performs characteristic compensation and filtering, "22" denotes a filtered digital modulation output signal, "23" denotes a combiner, "25" denotes a modulated carrier signal, "26" denotes a digital $\Sigma\text{-}\triangle$ modulation section, and "27" denotes a control signal output from digital $\Sigma\text{-}\triangle$ modulation section 26.

The operation will be described below in the above-mentioned configuration. Loop filter 18 smoothes a control signal which is modulated in digital $\Sigma\text{-}\triangle$ modulation section 26, compared with a reference signal in phase comparator 16 and output. At this point, the control signal looses a high-frequency component by band limitation of loop filter 18. Therefore, a difference in characteristics is calculated between a loop filter having an ideal band and actually used loop filter 18, and using the difference as a compensation function, digital processor 21 compensates the digital modulation data. As described above, by multiplying the digital modulation data by a difference in characteristics between actual loop filter 18 used in PLL modulation apparatus 10 and the ideal loop filter that does not generate a phase distortion, it is possible to apparently expand a loop bandwidth of PLL modulation apparatus 10 and improve characteristics while suppressing generation of a phase distortion.

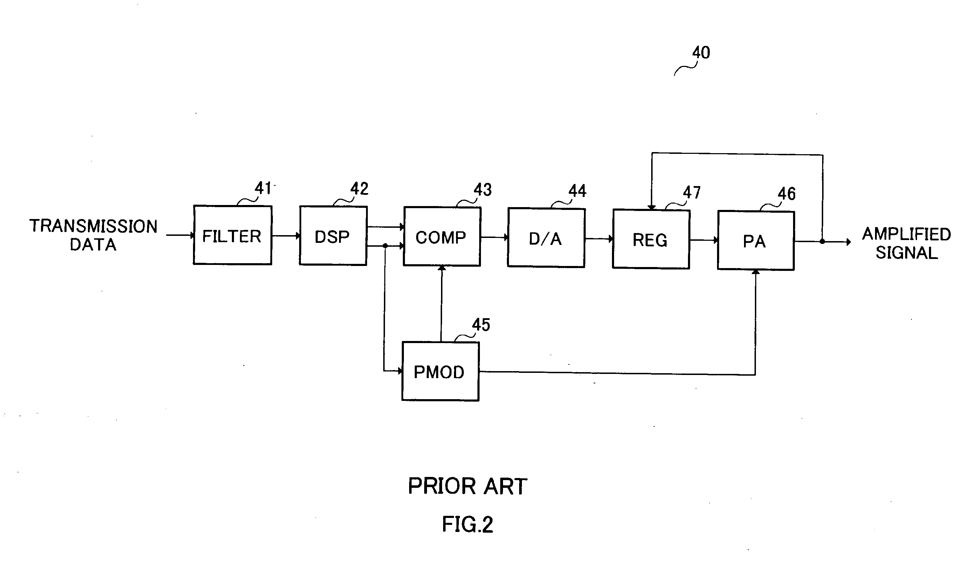

Further, as a method of compensating for a phase distortion caused by a modulator in the polar coordinate modulation system, there are proposed a method and apparatus for providing a compensation circuit for compensating an amplitude component of a polar coordinate modulation signal, and thereby compensating for a phase distortion (for example, see Patent Document 2). FIG.2 shows an example of an apparatus that generates a linear modulation signal using the conventional polar coordinate modulation system. In FIG.2, apparatus 40 that generates a linear modulation signal using the polar coordinate modulation system is mainly comprised of digital waveform filter (FILTER) 41, digital signal processor (DSP) 42, compensation circuit (COMP) 43, D/A converter (D/A) 44, phase modulator (PMOD) 45, power amplifier (PA) 46 and regulator (REG) 47.

The operation will be described below in the above-mentionedconfiguration. Digital waveform filter 41 converts transmission data into a digital waveform and outputs to digital • signal • processor 42. Digital • signal • processor 42 separates the transmission data input from digital waveform filter 41 into a phase component and amplitude component and outputs to phase modulator 45 and compensation circuit 43. Phase modulator 45 modulates a carrier signal with the phase component and obtains constant envelop phase modulation. At this point, in phase modulator 45, a phase distortion occurs in the phase-modulated carrier signal.

To compensate the phase distortion to supply a linear modulation signal, compensation circuit 43 compensates an amplitude component input from digital signal processor 42 and compensates for the phase distortion caused by phase modulator 45. For example, compensation circuit 43 derives a compensation function based on delay occurred in phase modulator 45, ideal phase component and distorted phase component, and compensates the amplitude component. Then, compensation circuit 43 outputs the compensated digital amplitude component to D/A converter 44.

D/A converter 44 converts the input compensated digital amplitude component into an analog signal and outputs to regulator 47. Based on the analog signal and an output signal of power amplifier 46, regulator 47 outputs to power amplifier 46 an analog signal obtained by adjusting a current or voltage of a signal controlling the power of power amplifier 46 to a target value. Power amplifier 46 controls the power of the power amplifier with the input analog signal, thereby modulates the phase-modulated carrier signal input from phase modulator 45, and outputs an amplified signal.

By adopting such a configuration, communication systems using the polar coordinate modulation system makes it possible to compensate for a phase distortion generated in a phase modulator to improve accuracy in modulation, and further, cancel the distortion caused by the phase distortion to meet spectral requirements for signal transmission.

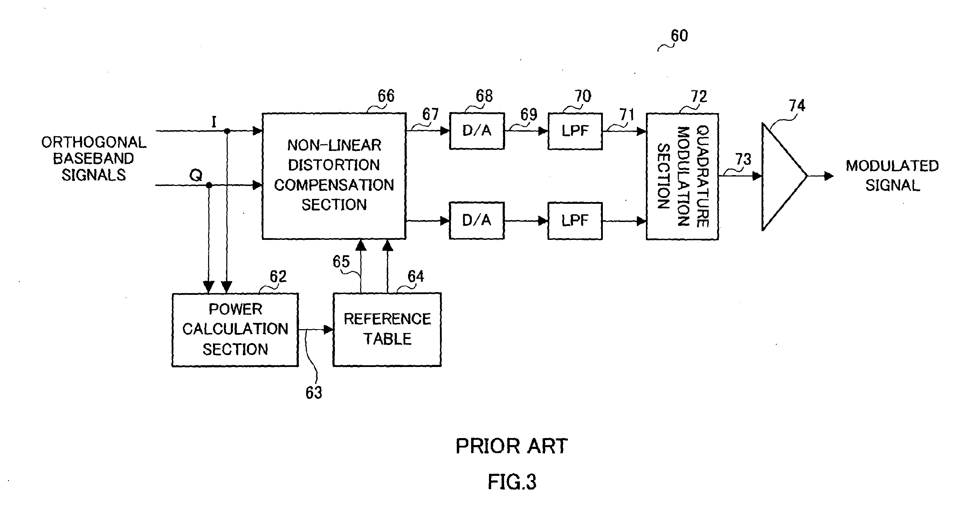

An application of pre-distortion technique may be considered as a technique compensating for a distortion component of the frequency spectrum caused by deterioration of characteristics in the PLL modulation section, (for example, see Patent Document 3). FIG.3 shows a schematic block diagram of conventional pre-distortion apparatus 60. In FIG.3, "62" denotes a power calculation section, "63" denotes an amplitude value calculated in power calculation section 62, "64" denotes a reference table for non-linear distortion compensation, "65" denotes orthogonal non-linear distortion compensation data, "66" denotes a non-linear distortion compensation section, "67" denotes a non-linear distortion compensated orthogonal baseband signal, "68" denotes a D/A conversion section (D/A), "69" denotes an analog orthogonal baseband signal, "70" denotes a low-pass filer (LPF) for band limitation, "71" denotes a band-limited analog orthogonal baseband signal, "72" denotes a quadrature modulation section, "73" denotes a modulated signal, and "74" denotes an amplifier of the transmission system.

The operation will be described below in the above-mentioned configuration. First, power calculation section 62 calculates an amplitude value 63 of a transmission signal from transmission digital orthogonal baseband signals. Next, the section 62 refers to the reference table 64 for non-linear distortion compensation using the calculated amplitude value 63 of the transmission signal as an address, and obtains non-linear distortion compensation data 65 obtained by orthogonalizing the non-linear distortion compensation data having non-linear distortion characteristics of the transmission system calculated beforehand.

Non-linear distortion compensation section 66 performs complex-multiplication of the orthogonal baseband signal by orthogonalized non-liner distortion compensation data 65 and outputs the non-linear distortion compensated orthogonal baseband signal 67. D/A conversion section 68 converts the non-linear distortion compensated orthogonal baseband signal 67 into an analog signal, and low-pass filter 70 performs band limitation on the analog signal and obtains the analog orthogonal baseband signal 71. Then, quadrature modulation section 72 performs quadrature modulation and obtains the modulated signal 73, and amplifier 74 of the transmission system amplifies the signal to a required level and outputs a transmission modulated signal.

As described above, by providing power calculation section 62, reference table 64 for non-linear distortion compensation and non-linear distortion compensation section 66, referring to table 64 for non-linear distortion compensation using amplitude value 63 of the orthogonal baseband signal, and performing complex-multiplication of the orthogonal baseband signal by orthogonalized non-liner distortion compensation data 65 by non-linear distortion compensation section 66 performs, and it is thereby possible to compensate for the non-linear distortion occurring in the amplifier in the transmission system.

Patent Document 1: USP 6,008,703
Patent Document 2: JP 2002-527921
Patent Document 3: JP H08-251246

Disclosure of Invention

Problems to be Solved by the Invention

However, the conventional apparatus has a problem that the technique for compensating a baseband signal to expand a loop bandwidth of PLL can be applied only to digital $\Sigma$-$\triangle$ modulation, and cannot be applied in the conventional analog PLL modulation system.

Further, in the conventional apparatus, when a compensation circuit is provided and an amplitude component of a polar coordination modulation signal is compensated to compensate for a phase distortion, since the amplitude component is used to compensate for the phase distortion in a phase modulator, it is necessary to delay the amplitude component by time equal to delay occurred in the phase modulator. The adjustment of delay time significantly affects the phase distortion compensation effect, and there is a problem that the delay time should be controlled with high accuracy. Furthermore, when the conventional apparatus uses the polar coordinate modulation system, at lease two timing adjustments are required such as an adjustment of delay time in the compensation circuit and timing adjustment in combining a signal after phase modulation and amplitude modulation is finished, and there is a problem requiring highly accurate timing adjustments. Moreover, in the conventional apparatus, since the amplitude component is used to compensate for the phase distortion in the phase modulator, there is a problem that the phase distortion cannot be compensated incommunication systems using modulation systems such as GSMK that do not need amplitude modulation.

Further, in the conventional apparatus, in the case of using the pre-distortion technique, it is necessary to prepare a reference table associated with amplitude values, resulting in a problem that the reference table becomes enormous.

It is an object of the present invention to provide a modulation apparatus and modulation method which can be applied to the conventional analog PLL modulation system without using an enormous reference table, enable a phase distortion to be compensated accurately without requiring timing control with high accuracy, and can be applied to communication systems that do not perform amplitude modulation.

Means for Solving the Problem

A modulation apparatus of the present invention adopts a configuration provided with modulating means for modulating a baseband signal to generate a modulated signal, and compensating means for beforehand compensating a non-modulated baseband signal for a phase distortion between the non-modulated baseband signal prior to modulation in the modulating means and a modulation-processed baseband signal subjected to modulation in the modulating means, based on a magnitude of a phase change between adjacent data of the baseband signal and a predetermined constant.

A modulation method of the present invention has a step of modulating a baseband signal to generate a modulated signal, obtaining a phase distortion between a non-modulated baseband signal that is a baseband signal prior to modulation and a modulation-processed baseband signal that is a baseband signal subjected to modulation by multiplying a magnitude of a phase change between adjacent data of the baseband signal by a stored predetermined constant, and beforehand compensating the non-modulated baseband signal for the obtained phase distortion.

Advantageous Effect of the Invention

According to the present invention, it is possible to extend applicability to the conventional analog PLL modulation system without using an enormous reference table, compensate a phase distortion accurately without requiring timing control with high accuracy, and also extend applicability to communication systems that do not perform amplitude modulation.

Brief Description of Drawings

FIG.1 is a block diagram illustrating a configuration ofaconventionalcommunication apparatus;
FIG.2 is a block diagram illustrating a configuration of another conventional communication apparatus;
FIG.3 is a block diagram illustrating a configuration of another conventional communication apparatus;
FIG.4 is a block diagram illustrating a configuration of a communication apparatus according to Embodiment 1 of the present invention;
FIG. 5 is a graph showing time shift of a phase distortion and 1-component waveform data of baseband phase signal according to Embodiment 1 of the invention;
FIG.6 is a block diagram illustrating a configuration of a communication apparatus according to Embodiment 2 of the invention;
FIG.7 is a block diagram illustrating a configuration of a communication apparatus according to Embodiment 3 of the invention;
FIG.8 is a block diagram illustrating a configuration of a communication apparatus according to Embodiment 4 of the invention;
FIG.9 is a block diagram illustrating a configuration of a communication apparatus according to Embodiment 5 of the invention;
FIG.10 is a block diagram illustrating a configuration of a communication apparatus according to Embodiment 6 of the invention;
FIG.11 is a block diagram illustrating a configuration of a communication apparatus according to Embodiment 7 of the invention;
FIG.12 is a block diagram illustrating a configuration of a communication apparatus according to Embodiment 8 of the invention;
FIG.13 is a block diagram illustrating a configuration of a communication apparatus according to Embodiment 9 of the invention; and

FIG.14 is a table illustrating the relationship between a magnitude of a frequency change and parameter according to Embodiment 10 of the invention.

Best Mode for Carrying Out the Invention

It is a gist of the invention to beforehand compensate a non-modulated baseband signal prior to modulation in a modulator using a phase distortion between the non-modulated baseband signal prior to modulation in the modulator and a demodulated baseband signal which is modulated in the modulator and then demodulated in a demodulator, based on a magnitude of a frequency change of the baseband signal at predetermined time.

Embodiments of the invention will specifically be described below with reference to accompanying drawings.

(Embodiment 1)

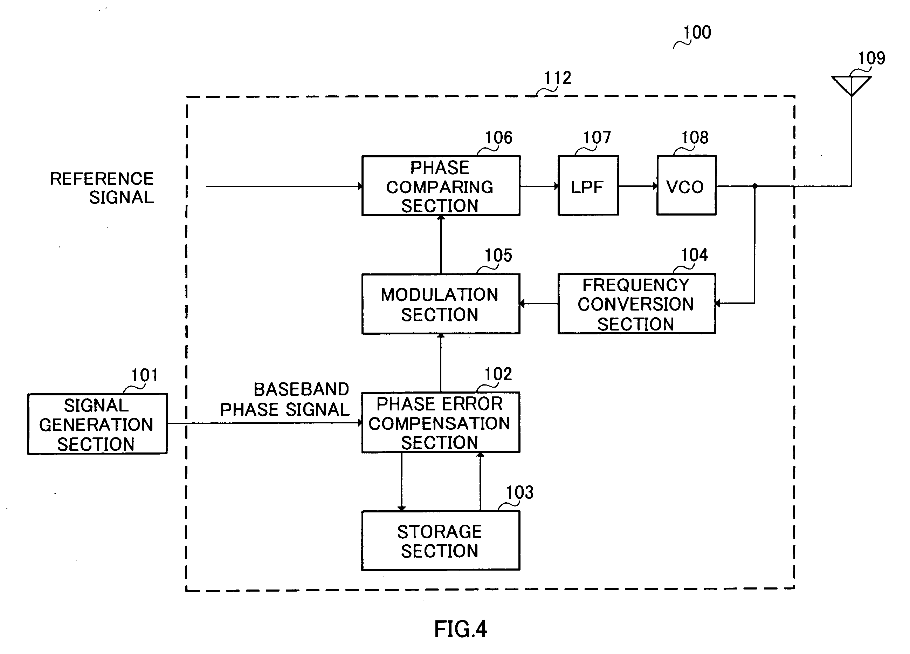

FIG.4 is a block diagram illustrating a configuration of communication apparatus 100 according to Embodiment 1 of the invention.

Modulation apparatus 112 is comprised of phase distortion compensation section 102, storage section 103, frequency conversion section 104, modulation section 105, phase comparing section 106, LPF 107 and VCO 108. In addition, communication apparatus 100 is assumed to show a phase locked loop (hereinafter, referred to as "PLL") modulation apparatus.

Signal generating section 101 generates a baseband phase signal, and outputs the generated baseband phase signal to phase distortion compensation section 102.

Whenever a baseband phase signal is input from signal generation section 101, phase distortion compensation section 102 that is the compensating means calculates an estimated phase distortion assumed to occur by modulation processing of the baseband signal, using a magnitude of a frequency change at predetermined time obtained from the baseband phase signal or a magnitude of a phase change between adjacent data obtained from the baseband signal and a calculation equation and parameter both stored in storage section 103, compensates the baseband phase signal input from signal generation section 101 for the calculated phase distortion and outputs to modulation section 105. In addition, a method of calculating a phase distortion will be described later.

Storage section 103 stores a calculation equation to obtain a phase distortion from a relational equation between a parameter that is a constant and the magnitude of the frequency change or a relational equation between a parameter that is a constant and the magnitude of the phase change, and the parameter beforehand obtained using the calculation equation, and outputs information of the stored calculation equation and information of the parameter to phase distortion compensation section 102 when the compensation section 102 compensates a baseband phase signal.

Frequency conversion section 104 converts the frequency of a modulation output signal input from voltage control oscillator (hereinafter, referred to as "VCO") 108 into a frequency of a signal to be a reference to generate a frequency converted signal, and outputs the frequency converted signal to modulation section 105.

Modulation section 105 is, for example, a quadrature modulator, modulates the frequency converted signal input from frequency conversion section 104 using the compensated baseband phase signal input from phase distortion compensation section 102, generates a modulated signal and outputs the generated modulated signal to phase comparing section 106.

Phase comparing section 106 compares a phase of the modulated signal input from modulation section 105 and a phase of the reference signal, and outputs an distortion signal that is the result of comparison to LPF 107.

LPF 107 smoothes the distortion signal input from phase comparing section 106 and outputs to VCO 108.

Using the distortion signal input from LPF 107 as a control signal, VCO 108 outputs a modulated output signal with an oscillation frequency determined by the control signal to frequency conversion section 104, while transmitting the modulated output signal via antenna 109. Modulation processing is finished by VCO 108 outputting the modulated output signal.

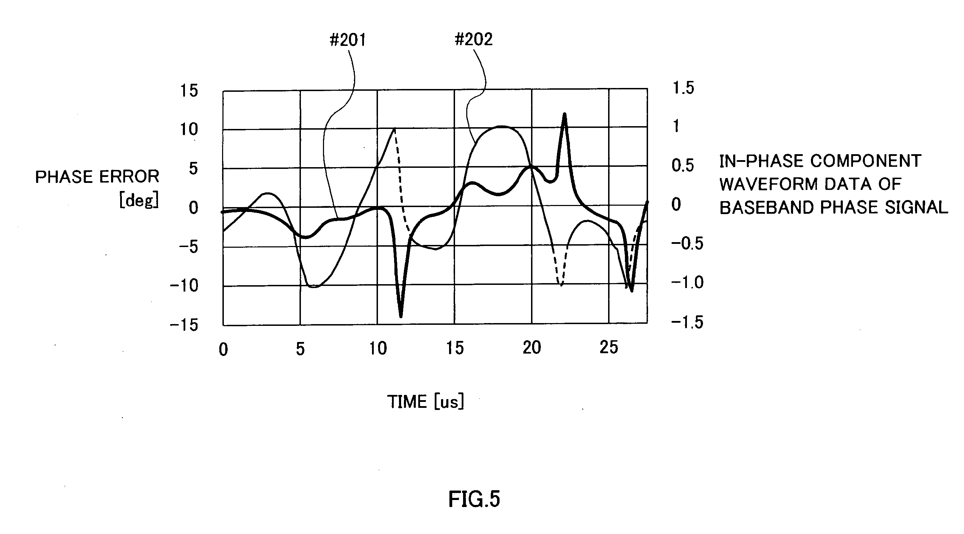

Referring to FIG.5, described next is a method of compensating for the phase distortion in the baseband phase signal output from signal generation section 101. FIG.5 is a graph showing time shift of phase distortion #201 and I-component (in-phase component) waveform data #202 of baseband phase signal.

In communication apparatus 100, LPF 107 and others have frequency characteristics. When a bandwidth of communication apparatus 100 is sufficiently wide relative to a maximum frequency component of a modulated output signal output from VCO 108, frequency characteristics of communication apparatus 100 do not become a problem. However, when a bandwidth of communication apparatus 100 is not obtained sufficiently widely relative to a maximum frequency component of a modulated output signal, the phase distortion $\Delta\theta$ occurs in a modulated output signal output from VCO 108 by frequency characteristics of communication apparatus 100.

FIG.5 shows the phase distortion $\Delta\theta$ of a modulated output signal on waveform data of an in-phase component of a baseband phase signal, where a symbol rate of the baseband phase signal output from signal generation section 101 is 270.833ksymb/s, and a loop bandwidth is about 1MHz. It is understood from FIG.5 that the phase distortion $\Delta\theta$ is large at a position where the waveform data of the baseband phase signal changes sharply. Herein, the phase distortion $\Delta\theta$ is a difference between a baseband phase signal prior to modulation (non-modulated baseband signal) and a signal (modulation-processed baseband signal) obtained by demodulating a modulated output signal. As can be seen from FIG.5, a phase distortion of about $\pm13$ degrees occurs even when an about four-time loop bandwidth is secured. Accordingly, in order for a reception side to be able to demodulate data with accuracy, it is necessary to compensate the phase distortion $\Delta\theta$ in phase distortion compensation section 102 so that a phase signal of a modulated output signal is the same as a baseband phase signal.

The variation in baseband phase signal is expressed by a magnitude of a frequency change per unit time, and the phase distortion and the magnitude of the frequency change per unit time are expressed by a relational equation (1).

$$\Delta\theta = \alpha \cdot F \qquad\qquad (1)$$

where

 $\Delta\theta$: phase distortion;
 $\alpha$ : parameter; and
 F : magnitude of frequency change.

Here, the parameter $\alpha$ is a coefficient determined by characteristics of communication apparatus 100. Equation (1) indicates that it is possible to estimate the phase distortion $\Delta\theta$ occurring in communication apparatus 100 when the magnitude of the frequency change F per unit time of a baseband phase signal is know.

Described next is the relationship between a phase amount $\theta$ of each data of a baseband phase signal and the magnitude of the frequency change F per unit time. Here, in phase distortion compensation section 102, considering a data sequence of a discrete baseband phase signal, (n-1)th data (for example, (n-1)th frame) and nth data (for example, nth frame) have the relationship as in equation (2).

$$f(n-1) = (\theta(n) - \theta(n-1)) / (2 \cdot \pi \cdot t) \qquad\qquad (2)$$

where

 f(n-1) : frequency component determined by the (n-1)th data and nth data;
 $\theta(n)$ : phase amount of the nth data;
 $\theta(n-1)$ : phase amount of the (n-1)th data; and
 t: time difference between data of the baseband phase signal.

Further, using a frequency component determined by the nth data and (n+1) th data (for example, (n+1) thframe), the magnitude of the frequency change per unit time in nth data is obtained from equation (3).

$$F(n) = (f(n) - f(n-1)) / t$$

$$= (\theta(n+1) + \theta(n-1) - 2 \cdot \theta(n)) / (2 \cdot \pi \cdot t^2) \qquad (3)$$

where

 F(n) : magnitude of frequency change per unit time in the nth data;
 f(n) : frequency component determined by the nth data and (n+1)th data;
 f (n-1) : frequency component determined by the (n-1) th data and nth data;
 $\theta(n+1)$ : phase amount of the (n+1) th data;

θ(n-1) : phase amount of the (n-1) th data;
θ(n) : phase amount of the nth data; and
t: time difference between data of the baseband phase signal.

Equation (3) indicates that a magnitude of a phase change between adjacent data is converted into a magnitude of a frequency change. In other words, the equation suggests that with respect to a phase amount θ(n) of the nth data, when a phase amount θ(n-1) one data previous to the nth data and a phase amount θ(n+1) one data subsequent to the nth data are known, the magnitude of the frequency change F(n) per unit time in the nth data can be derived from simple calculation. Accordingly, using the magnitude of the frequency change obtained from the magnitude of the phase change and parameter, it is possible to obtain the phase distortion from equation (1). Further, with respect to the nth data, the magnitude of the frequency change F(n) per unit time in the nth data is obtained from phase amounts of the (n-1) th data and the (n+1)th data, and from equations (1) and (3), as expressed in equation (4), the relational equation is derived between the phase amount of the nth data and the phase distortion in the data.

$$\Delta\theta(n) = \alpha \cdot (\theta(n+1) + \theta(n-1) - 2 \cdot \theta(n)) / (2 \cdot \pi \cdot t^2) \quad (4)$$

where

$\Delta\theta(n)$: phase distortion imposed on nth data
$\alpha$ : parameter
θ(n+1) : phase amount of the (n+1) th data;
θ(n-1) : phase amount of the (n-1) th data;
θ (n) : phase amount of nth data; and
t: time difference between data of the baseband phase signal.

Accordingly, since it is possible to estimate the phase distortion $\Delta\theta(n)$ imposed on the nth data from equation (4), the estimated phase distortion $\Delta\theta(n)$ is obtained using the phase amount θ(n) of nth data from equation (4), phase distortion compensation section 102 compensates for the phase distortion $\Delta\theta(n)$ in the nth data, and it is thereby possible to compensate the phase distortion $\Delta\theta$ of a modulated output signal of the nth data output from VCO 108. In other words, it is possible to obtain the phase distortion $\Delta\theta(n)$ of the nth data from the phase amount variation between adjacent data and the parameter.

The parameter stored in storage section 103 can be obtained by calculating a phase distortion by subtracting between a phase of a baseband signal before being modulated in modulation section 105 and a phase of the modulated output signal output from VCO 108, and dividing the obtained phase distortion by the magnitude of the frequency change of predetermined time from equation (1), before starting data communication.

As described above, equation (4) is used when the phase distortion is obtained based on the magnitude of the phase change of adjacent data and predetermined constant, while equation (1) is used when the phase distortion is obtained based on the magnitude of the frequency change at predetermined time and predetermined constant. Further, when the phase distortion is obtained based on the magnitude of the phase change between adj acent data and predetermined constant, the parameter stored in storage section 103 can be obtained by calculating a phase distortion by subtracting between a phase of a baseband signal before being modulated in modulation section 105 and a phase of the modulated output signal output from VCO 108, and dividing the obtained phase distortion by the magnitude of the phase change between adjacent data from equation (4), before starting data communication. It is thereby possible to compensate a phase distortion without using the magnitude of the frequency change.

Thus, according to Embodiment 1, a parameter is first stored that is obtained from a magnitude of a frequency change at predetermined time or a magnitude of a phase change between adjacent data of a baseband phase signal and a phase distortion, the magnitude of the frequency change at predetermined time or the magnitude of the phase change between adjacent data is obtained on each data of the baseband phase signal, a phase distortion is estimated using the obtained magnitude of frequency change or magnitude of phase change and the stored parameter, the estimated phase distortion is beforehand compensated for the baseband phase signal, and it is thereby possible to compensate the phase distortion using only the baseband phase signal. By this means, it is possible Embodiment 1 to apply to the conventional analog PLL modulation system without using an enormous reference table, compensate a phase distortion accurately without requiring timing control with high accuracy, and use in communication systems that do not perform amplitude modulation. Further, according to Embodiment 1, the phase distortion can be calculated from a stored predetermined equation, and it is thus possible to obtain the phase distortion with a simplified method.

(Embodiment 2)

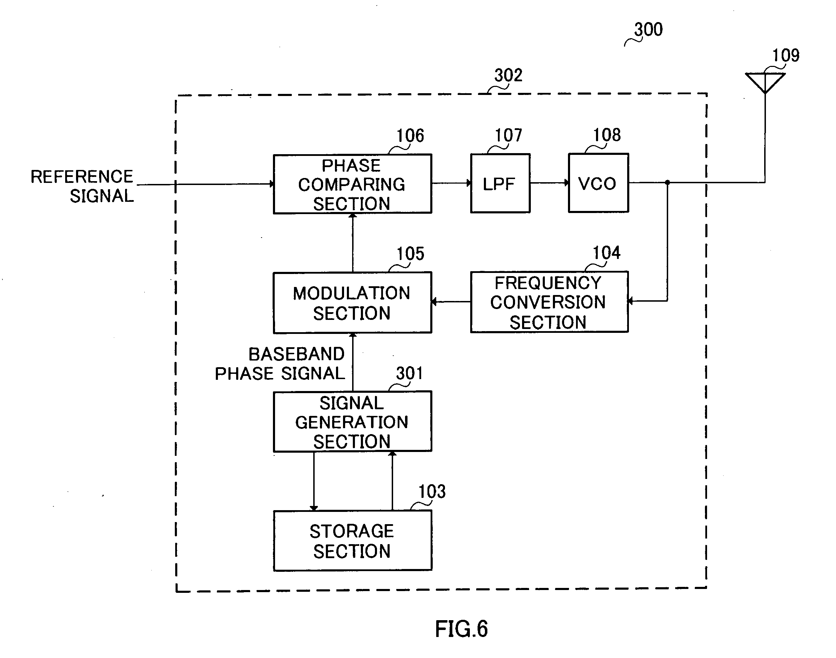

FIG.6 is a block diagram illustrating a configuration of communication apparatus 300 according to Embodiment 2 of the invention.

Modulation apparatus 302 is comprised of storage section 103, frequency conversion section 104, modulation section 105, phase comparing section 106, LPF 107, VCO 108 and signal generation section 301.

As shown in FIG.6, communication apparatus 300 according to Embodiment 2 includes signal generation section 301 instead of signal generation section 101 with phase distortion compensation section 102 eliminated in communication apparatus 100 according to Embodiment 1 as shown in FIG.4. In addition, in FIG.6, the same sections as in FIG.4 are assigned the same reference numerals and descriptions thereof are omitted.

Signal generation section 301 is, for example, a DSP (Digital Signal Processor) capable of compensating a phase distortion by digital signal processing, generates a baseband phase signal, calculates a phase distortion using a magnitude of a frequency change obtained from the generated baseband phase signal and a calculation equation and parameter both stored in storage section 103, and compensates the baseband phase signal input from signal generation section 301 for the calculated phase distortion to output to modulation section 105. In addition, a method of obtaining a phase distortion is the same as in Embodiment 1, and descriptions thereof are omitted.

Thus, according to Embodiment 2, in addition to the effect of above-mentioned Embodiment 1, it is possible to perform generation of a baseband phase signal and compensation of phase distortion to the baseband phase signal by successive digital signal processing, and increase the processing speed to compensate the phase distortion.

(Embodiment 3)

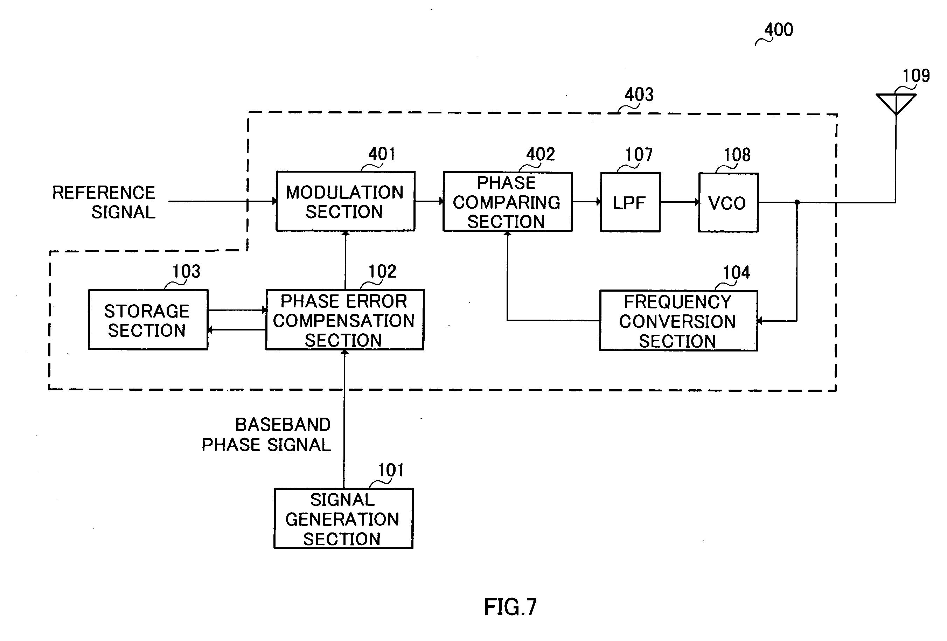

FIG.7 is a block diagram illustrating a configuration of communication apparatus 400 according to Embodiment 3 of the invention.

Modulation apparatus 403 is comprised of phase distortion compensation section 102, storage section 103, frequency conversion section 104, LPF 107, VCO 108, modulation section 401 and phase comparing section 402.

As shown in FIG.7, communication apparatus 400 according to Embodiment 3 includes modulation section 401 and phase comparing section 402 instead of modulation section 105 and phase comparing section 106 respectively in communication apparatus 100 according to Embodiment 1 as shown in FIG.4. In addition, in FIG.7, the same sections as in FIG.4 are assigned the same reference numerals to omit descriptions thereof.

Modulation section 401 is, for example, a quadrature modulator, modulates a compensated baseband phase signal input form phase distortion compensation section 102 using a reference signal, generates a modulated signal and outputs the generated modulated signal to phase comparing section 402.

Phase comparing section 402 compares a phase of the modulated signal input from modulation section 401 and a phase of the frequency converted signal input from frequency conversion section 104 and outputs an distortion signal that is the result of comparison to LPF 107. In addition, a method of compensating a phase distortion is the same as in Embodiment 1, and descriptions thereof are omitted.

Thus, according to Embodiment 3, a parameter is first stored that is obtained from a magnitude of a frequency change at predetermined time or a magnitude of a phase change between adjacent data of a baseband phase signal and a phase distortion, the magnitude of the frequency change at predetermined time or the magnitude of the phase change between adjacent data is obtained on each data of the baseband phase signal, a phase distortion is estimated from the obtained magnitude of frequency change or magnitude of phase change and the stored parameter, the estimated phase distortion is beforehand compensated for the baseband phase signal, and it is thereby possible to compensate the phase distortion using only the baseband phase signal. By this means, it is possible to apply Embodiment 3 to the conventional analog PLL modulation system without using an enormous reference table, compensate a phase distortion accurately without requiring timing control with high accuracy, and also use Embodiment 3 in communication systems that do not perform amplitude modulation. Further, according to Embodiment 3, the phase distortion can be calculated from a stored predetermined equation, and it is thus possible to obtain the phase distortion with a simplified method.

(Embodiment 4)

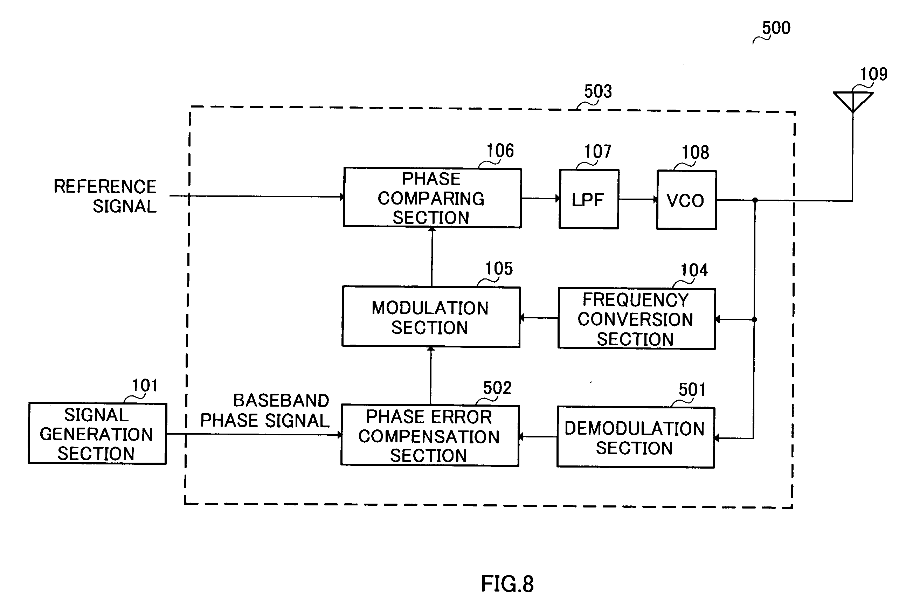

FIG.8 is a block diagram illustrating a configuration of communication apparatus 500 according to Embodiment 4 of the invention.

Modulation apparatus 503 is comprised of frequency conversion section 104, modulation section 105, phase comparing section 106, LPF 107, VCO 108, demodulation section 501 and phase distortion compensation section 502.

As shown in FIG.8, communication apparatus 500 according to Embodiment 4 includes phase distortion compensation section 502 instead of phase distortion compensation section 102 with storage section 103 eliminated and demodulation section 501 added in communication apparatus 100 according to Embodiment 1 as shown in FIG.4. In addition, in FIG.8, the same sections as in FIG.4 are assigned the same reference numerals and descriptions thereof are omitted.

Demodulation section 501 demodulates a modulated output signal input from VCO 108 to generate a baseband phase signal (demodulated baseband signal), and outputs the generated baseband phase signal to phase distortion compensation section 502. Demodulation section 501 may be used as a demodulation section in the reception system that demodulates a received signal, or may be provided separated from the demodulation section in the reception system.

Phase distortion compensation section 502 obtains a phase distortion by subtracting the modulation-processed baseband phase signal input from demodulation section 501 from the non-modulated baseband phase signal input from signal generation section 101, and obtains a parameter $\alpha$ using the obtained phase distortion and a magnitude of a frequency change or a magnitude of a phase change obtained from the non-modulated baseband phase signal. Then, phase distortion compensation section 502 multiples the magnitude of the frequency change or the magnitude of the phase change obtained from the baseband phase signal by the parameter $\alpha$ to calculate a phase distortion, compensates the calculated phase distortion for the baseband phase signal input from signal generation section 101 and outputs to modulation section 105. In addition, after the baseband phase signal is demodulated, a phase difference between the non-modulated baseband phase signal and modulation-processed baseband phase signal obtained in phase distortion compensation section 502 is a phase distortion of an already transmitted signal . Therefore, a phase distortion in next transmitting a signal is obtained from equation (1) using the parameter $\alpha$ obtained from the non-modulated baseband phase signal and modulation-processed baseband phase signal. It is thereby possible to obtain an accurate phase distortion.

Thus, according to Embodiment 4, in addition to the effect of above-mentioned Embodiment 1, since the transmission side demodulates a modulated output signal and calculates the parameter $\alpha$ at each demodulation, and therefore, it is possible to accurate parameter $\alpha$ and also compensate a phase distortion with remarkably high accuracy. Furthe r, according to Embodiment 4, when demodulation section 501 is used as the demodulation section in the reception system, it is possible to compensate a phase distortion with remarkably high accuracy without changing a circuit scale, and perform phase distortion compensation in real time with a simplified circuit configuration. Furthermore, according to Embodiment 4, it is not necessary to store the parameter $\alpha$ beforehand, and it is thus possible to reduce a storage capacity of the storage section (memory) .

In addition, in Embodiment 4, phase distortion compensation section 502 obtains the parameter $\alpha$ each time, but the invention is not limited thereto. A storage section storing the obtained parameter $\alpha$ may be provided and a phase distortion may be calculated using the stored parameter $\alpha$ before a lapse of predetermined time.

(Embodiment 5)

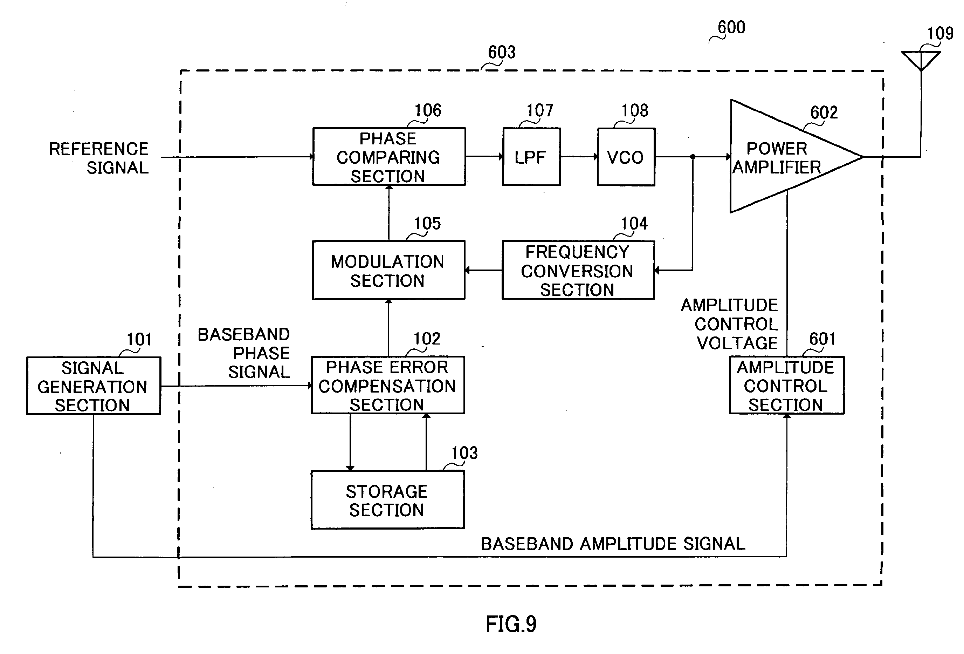

FIG.9 is a block diagram illustrating a configuration of communication apparatus 600 according to Embodiment 5 of the invention. Modulation apparatus 603 is comprised of phase distortion compensation section 102, storage section 103, frequency conversion section 104, modulation section 105, phase comparing section 106, LPF 107, VCO 108, amplitude control section 601 and power amplifier 602. In addition, communication apparatus 600 is assumed an apparatus of polar loop modulation apparatus that is one of polar coordinate modulation systems.

As shown in FIG.9, communication apparatus 600 according to Embodiment 5 adds amplitude control section 601 and power amplifier 602 in communication apparatus 100 according to Embodiment 1 as shown in FIG.4. In addition, in FIG.9, the same sections as in FIG.4 are assigned the same reference numerals and descriptions thereof are omitted.

Amplitude control section 601 controls an amplitude control voltage to apply to power amplifier 602 so that the power of power amplifier 602 is a target value, using a baseband amplitude signal input from signal generation section 101.

Power amplifier 602 amplifies a modulated signal input from VCO 108 based on control of amplitude control section 601 and transmits via antenna 109. In addition, a method of compensating a phase distortion is the same as in Embodiment 1, and descriptions thereof are omitted.

Thus, according to Embodiment 5, in addition to the effect of above-mentioned Embodiment 1, applicability is extended to modulation apparatus that perform amplitude modulation, and in modulation apparatus that performs modulation, a phase distortion can be compensated based on a baseband phase signal without using a baseband amplitude signal in the modulation apparatus, and therefore, it is possible to eliminate the timing adjustment with high accuracy and accurately obtain a phase distortion.

(Embodiment 6)

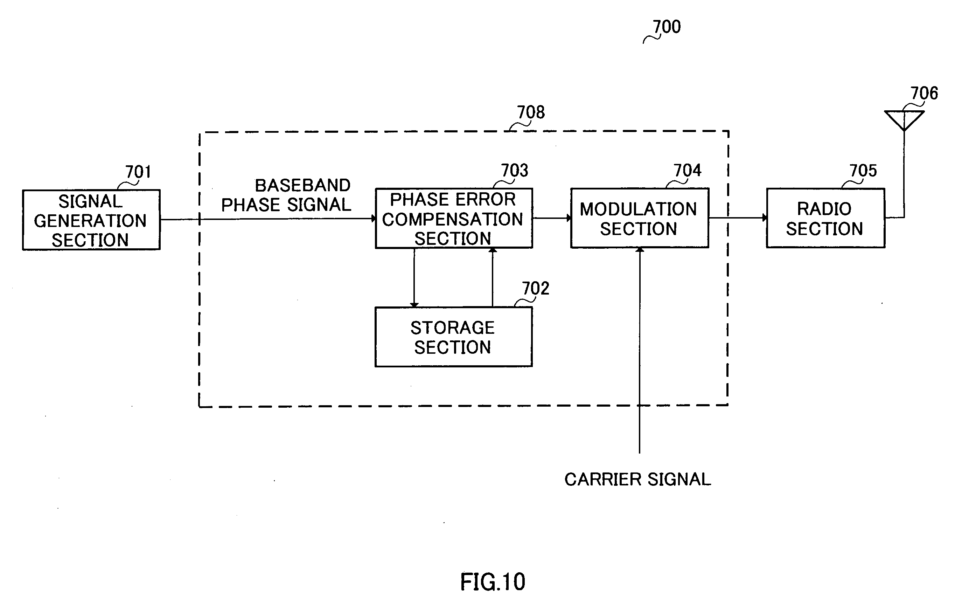

FIG.10 is a block diagram illustrating a configuration of communication apparatus 700 according to Embodiment 6 of the invention.

Modulation apparatus 708 is comprised of storage section 702, phase distortion compensation section 703 and modulation section 704.

Signal generating section 701 generates a baseband phase signal, and outputs the generated baseband phase signal to phase distortion compensation section 703.

Storage section 702 stores a calculation equation to obtain a phase distortion from a relational equation between a parameter and magnitude of frequency change, and the parameter obtained beforehand using the calculation equation, and outputs information of the stored calculation equation and information of the parameter to phase distortion compensation section 703 when the compensation section 703 compensates a baseband phase signal.

Whenever a baseband phase signal is input from signal generation section 701, phase distortion compensation section 703 calculates a phase distortion using a magnitude of a frequency change at predetermined time or a magnitude of a phase change between adjacent data obtained from the baseband phase signal and the calculation equation and parameter both stored in storage section 702, compensates the baseband phase signal input from signal generation section 701 for the calculated phase distortion and outputs to modulation section 704.

Modulation section 704 is, for example, a quadrature modulator, modulates a carrier signal using the compensated baseband phase signal input from phase distortion compensation section 703, generates a modulated signal and outputs the generated modulated signal to radio section 705. Modulation processing is finished by modulation section 704 outputting the modulated signal. In addition, a method of compensating a phase distortion is the same as in Embodiment 1, and descriptions thereof are omitted.

Radio section 705 performs upconverting processing or the like to the modulated output signal input from modulation section 704 from the baseband frequency to radio frequency and transmits via antenna 706. In addition, when modulation section 704 is directly comprised of a quadrature modulator or the like, upconverting from the baseband frequency to radio frequency can be performed simultaneously with modulation in modulation section 704. In this case, radio section 705 is not needed.

Thus, according to Embodiment 6, a parameter is first stored that is obtained from a magnitude of a frequency change at predetermined time or a magnitude of a phase change between adjacent data of a baseband phase signal and a phase distortion, the magnitude of the frequency change at predetermined time or the magnitude of the phase change between adjacent data is obtained on each data of the baseband phase signal, a phase distortion is estimated from the obtained magnitude of frequency change or magnitude of phase change and the stored parameter, the estimated phase distortion is beforehand compensated for the baseband phase signal, and it is thereby possible to compensate the phase distortion using only the baseband phase signal. By this means, it is possible Embodiment 6 to apply to the conventional analog PLL modulation system without using an enormous reference table, compensate a phase distortion accurately without requiring timing control with high accuracy, and also use Embodiment 6 in communication systems that do not perform amplitude modulation. Further, according to Embodiment 6, the phase distortion can be calculated from a stored predetermined equation, and it is thus possible to obtain the phase distortion with a simplified method.

(Embodiment 7)

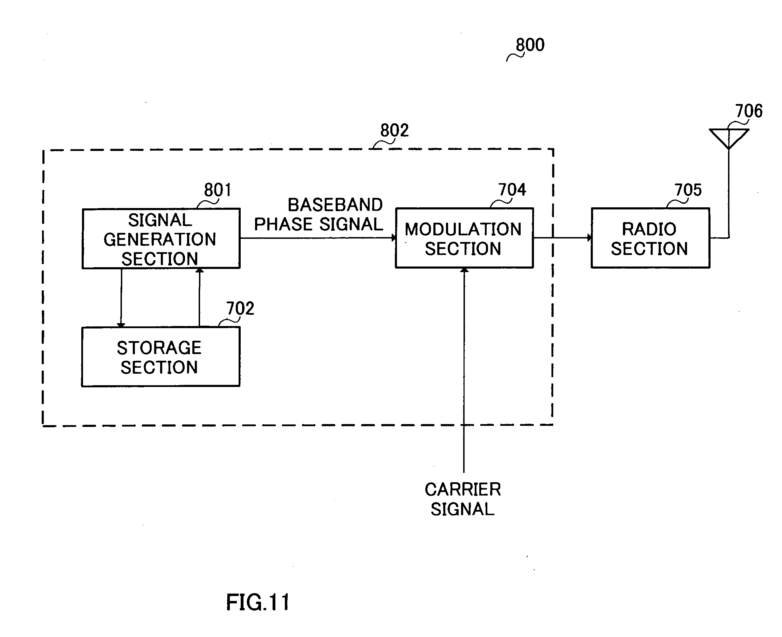

FIG.11 is a block diagram illustrating a configuration of communication apparatus 800 according to Embodiment 7 of the invention.

Modulation apparatus 802 is comprised of storage section 702, modulation section 704 and signal generation section 801.

As shown in FIG.11, communication apparatus 800 according to Embodiment 7 includes signal generation section 801 instead of signal generation section 701 with phase distortion compensation section 703 eliminated in communication apparatus 700 according to Embodiment 6 as shown in FIG.10. In addition, in FIG.11, the same sections as in FIG.10 are assigned the same reference numerals and descriptions thereof are omitted.

Signal generation section 801 is, for example, a DSP capable of compensating a phase distortion by digital signal processing, generates a baseband phase signal, calculates a phase distortion using a magnitude of a frequency change at predetermined time or a magnitude of a phase change between adjacent data from the generated baseband phase signal and a calculation equation and parameter both stored in storage section 702, compensates the baseband phase signal for the calculated phase distortion, performs D/A conversion on the compensated signal and outputs to modulation section 704 . In addition, a method of obtaining a phase distortion is the same as in Embodiment 1, and descriptions thereof are omitted.

Thus, according to Embodiment 7, in addition to the effect of above-mentioned Embodiment 6, it is possible to perform generation of a baseband phase signal and compensation of phase distortion to the baseband phase signal by successive digital signal processing, and increase the processing speed to compensate the phase distortion.

In addition, in Embodiment 7, the parameter is stored in storage section 702, but the invention is not limited thereto. The parameter may be obtained whenever signal generation section 801 outputs a baseband signal at predetermined timing.

(Embodiment 8)

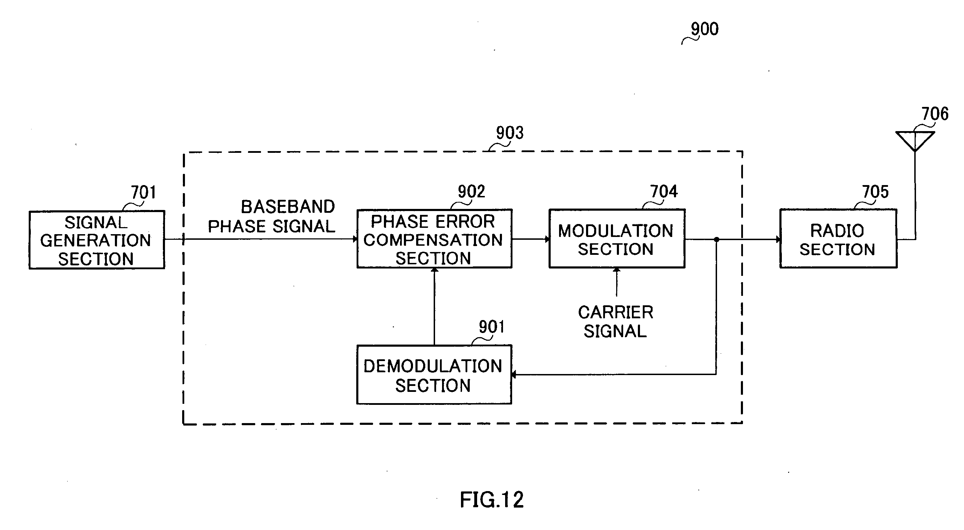

FIG.12 is a block diagram illustrating a configuration of communication apparatus 900 according to Embodiment 8 of the invention.

Modulation apparatus 903 is comprised of modulation section 704, demodulation section 901 and phase distortion compensation section 902.

As shown in FIG.12, communication apparatus 900 according to Embodiment 8 includes phase distortion compensation section 902 instead of phase distortion compensation section 703 with storage section 702 eliminated and demodulation section 901 added in communication apparatus 700 according to Embodiment 6 as shown in FIG. 10. In addition, in FIG.12, the same sections as in FIG. 10 are assigned the same reference numerals and descriptions thereof are omitted.

Demodulation section 901 demodulates a modulated output signal input from modulation section 704 to generate a baseband phase signal, and outputs the generated baseband phase signal to phase distortion compensation section 902. Demodulation section 901 may be used as a demodulation section in the reception system that demodulates a received signal, or may be provided separated from the demodulation section in the reception system.

Phase distortion compensation section 902 obtains a phase distortion by subtracting the modulation-processed baseband phase signal input from demodulation section 901 from the non-modulated baseband phase signal input from signal generation section 701, and obtains a parameter $\alpha$ using the obtained phase distortion and a magnitude of a frequency change at predetermined time or a magnitude of a phase change between adjacent data obtained from the non-modulated baseband phase signal. Then, phase distortion compensation section 902 multiples the magnitude of the frequency change or the magnitude of the phase change obtained from the baseband phase signal by the parameter $\alpha$, calculates a phase distortion, compensates the baseband phase signal input from signal generation section 701 for the calculated phase distortion and outputs to modulation section 704.

Thus, according to Embodiment 8, in addition to the effect of above-mentioned Embodiment 6, since the transmission side demodulates a modulated output signal and also calculates the parameter $\alpha$ at each demodulation, and therefore it is possible to obtain accurate parameter, and thereby possible to compensate a phase distortion with remarkably high accuracy. Further, according to Embodiment 8, when demodulation section 901 is used as the demodulation section in the reception system, it is possible to compensate a phase distortion with remarkably high accuracy without changing a circuit scale, and perform phase distortion compensation in real time with a simplified circuit configuration.

In addition, in Embodiment 8, phase distortion compensation section 902 obtains the parameter $\alpha$ each time, but the invention is not limited thereto. A storage section storing the obtained parameter $\alpha$ may be provided and a phase distortion may be calculated using the stored parameter $\alpha$ before a lapse of predetermined time.

(Embodiment 9)

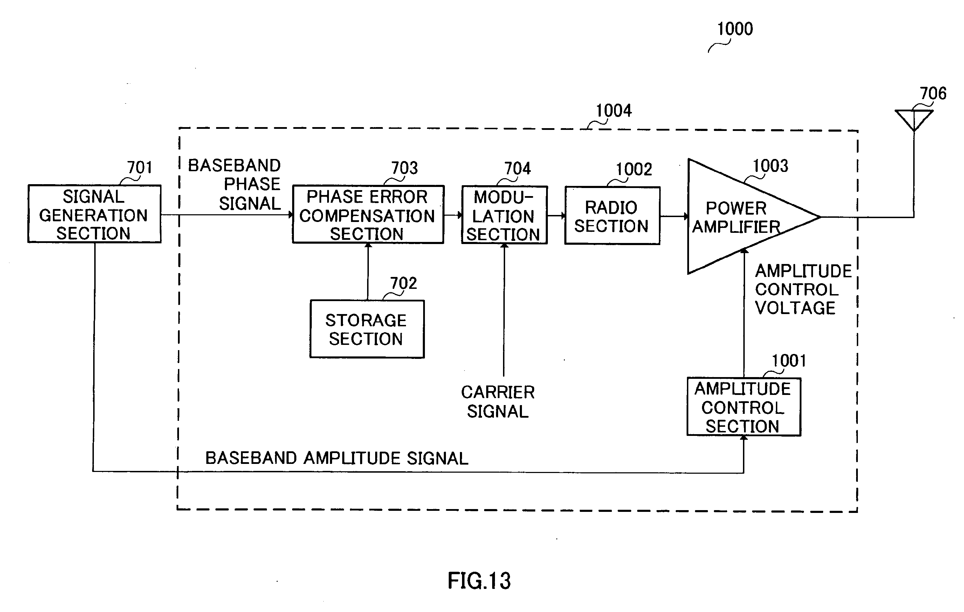

FIG.13 is a block diagram illustrating a configuration of communication apparatus 1000 according to Embodiment 9 of the invention.

Modulation apparatus 1004 is comprised of storage section 702, phase distortion compensation section 703, modulation section 704, amplitude control section 1001, radio section 1002 and power amplifier 1003. In addition, communication apparatus 1000 is assumed to show an EER (Envelop Elimination and Restoration) apparatus.

As shown in FIG.13, communication apparatus 1000 according to Embodiment 9 adds amplitude control section 1001 and power amplifier 1003 and includes radio section 1002 instead of radio section 705 in communication apparatus 700 according to Embodiment 6 as shown in FIG. 10 . In addition, in FIG.13, the same sections as in FIG.10 are assigned the same reference numerals and descriptions thereof are omitted.

Amplitude control section 1001 controls an amplitude control voltage to apply to power amplifier 1003 so that the power of power amplifier 1003 is a target value, using a baseband amplitude signal input from signal generation section 701.

Radio section 1002 performs processing of upconverting a modulated output signal input from modulation section 704 from the baseband frequency to radio frequency and the like and outputs to power amplifier 1003.

Power amplifier 1003 amplifies the modulated signal input from radio section 1002 based on control of amplitude control section 1001 and outputs as a modulated output signal. In addition, a method of compensating a phase distortion is the same as in Embodiment 1, and descriptions thereof are omitted.

Thus, according to Embodiment 9, in addition to the effect of above-mentioned Embodiment 6, applicability is extended to modulation apparatus that perform amplitude modulation, and in modulation apparatus that performs modulation, a phase distortion can be compensated based on a baseband phase signal without using a baseband amplitude signal in the modulation apparatus, and therefore, it is possible to eliminate the timing adjustment with high accuracy and accurately obtain a phase distortion.

(Embodiment 10)

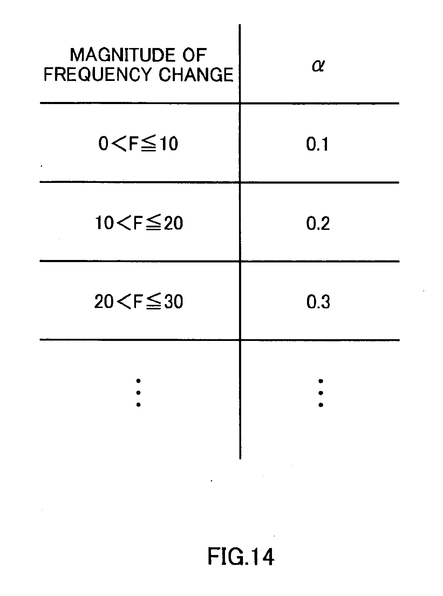

FIG.14 shows a table storing phase distortion selection information that associates the parameter α with magnitude of frequency change according to Embodiment 10 of the invention. In addition, a configuration of a communication apparatus is the same as the configuration in FIG.4, and descriptions thereof are omitted.

Storage section 103 stores the table as shown in FIG.14.

Whenever a baseband phase signal is input from signal generation section 101, phase distortion compensation section 102 selects parameter by using a magnitude of a frequency change at predetermined time or a magnitude of a phase change between adjacent data obtained from the baseband phase signal and referring to the phase distortion selection information stored in storage section 103, multiplies the selected parameter by the magnitude of the frequency change or the magnitude of the phase change, compensates the baseband phase signal input from signal generation section 101 for the calculated phase distortion and outputs to modulation section 105.

When the phase distortion is obtained using the magnitude of the frequency change, phase distortion compensation section 102 substitutes a compensation function of equation (5) for the compensation function of equation (1), and is thereby able to obtain a phase distortion corresponding to the magnitude of the frequency change. In equation (5), the parameter α is a function with the magnitude of the frequency change F per unit time as a parameter.

$$\Delta\theta = \alpha(F) \cdot F \ldots \quad (5)$$

where

$\Delta\theta$ : phase distortion;

$\alpha(F)$ : parameter; and

F : magnitude of frequency change.

Thus, according to Embodiment 10, in addition to the effect of above-mentioned Embodiment 1, the parameter is selected referring to the phase distortion selection information using the magnitude of the frequency change or the magnitude of the phase change, and therefore, it is possible to select a phase distortion corresponding to the magnitude of the frequency change or the magnitude of the phase change, and to compensate the phase distortion with accuracy.

In addition, the phase distortion is compensated in communication apparatus 100 in Embodiment 10, but the invention is not limited thereto. This method is applicable to the case of compensating a phase distortion in any one of communication apparatuses 300, 400, 600, 700, 800 and 1000.

The present application is based on Japanese Patent Applications No. 2003-362393 filed on October 22, 2003, and No. 2004-305807 filed on October 20, 2004, entire contents of which are expressly incorporated by reference herein.

Industrial Applicability

The present invention is suitable for use in particularly a modulation apparatus and modulation method for compensating a phase distortion to a baseband signal.

FIG. 1
13 FREQUENCY DIVIDER
16 PHASE COMPARATOR
REFERENCE SIGNAL
18 LOOP FILTER
OUTPUT MODULATED SIGNAL
21 DIGITAL PROCESSOR
DIGITAL MODULATION DATA
CARRIER SIGNAL
26 DIGITAL Σ-Δ MODULATION SECTION
FIG.2
TRANSMISSION DATA
AMPLIFIED SIGNAL
FIG.3
ORTHOGONAL BASEBAND SIGNALS

62 POWER CALCULATION SECTION
64 REFERENCE TABLE
66 NON-LINEAR DISTORTION COMPENSATION SECTION
72 QUADRATURE MODULATION SECTION
MODULATED SIGNAL
FIG.4
101 SIGNAL GENERATION SECTION
BASEBAND PHASE SIGNAL
102 PHASE DISTORTION COMPENSATION SECTION
103 STORAGE SECTION
104 FREQUENCY CONVERSION SECTION
105 MODULATION SECTION
106 PHASE COMPARING SECTION
REFERENCE SIGNAL
FIG.5
PHASE DISTORTION
IN-PHASE COMPONENT WAVEFORM DATA OF BASEBAND PHASE SIGNAL TIME
FIG.6
103 STORAGE SECTION
104 FREQUENCY CONVERSION SECTION
105 MODULATION SECTION
106 PHASE COMPARING SECTION
REFERENCE SIGNAL
BASEBAND PHASE SIGNAL
301 SIGNAL GENERATION SECTION
FIG.7
101 SIGNAL GENERATION SECTION
BASEBAND PHASE SIGNAL
102 PHASE DISTORTION COMPENSATION SECTION
103 STORAGE SECTION
104 FREQUENCY CONVERSION SECTION
401 MODULATION SECTION
REFERENCE SIGNAL
402 PHASE COMPARING SECTION
FIG.8
101 SIGNAL GENERATION SECTION
BASEBAND PHASE SIGNAL
104 FREQUENCY CONVERSION SECTION
105 MODULATION SECTION
106 PHASE COMPARING SECTION
REFERENCE SIGNAL
501 DEMODULATION SECTION
502 PHASE DISTORTION COMPENSATION SECTION
FIG.9
101 SIGNAL GENERATION SECTION
BASEBAND AMPLITUDE SIGNAL
BASEBAND PHASE SIGNAL
102 PHASE DISTORTION COMPENSATION SECTION
103 STORAGE SECTION
104 FREQUENCY CONVERSION SECTION
105 MODULATION SECTION
106 PHASE COMPARING SECTION
601 AMPLITUDE CONTROL SECTION
AMPLITUDE CONTROL VOLTAGE
602 POWER AMPLIFIER
FIG.10
701 SIGNAL GENERATION SECTION
BASEBAND PHASE SIGNAL

702 STORAGE SECTION
703 PHASE DISTORTION COMPENSATION SECTION
704 MODULATION SECTION
CARRIER SIGNAL
705 RADIO SECTION
FIG.11
702 STORAGE SECTION
704 MODULATION SECTION
BASEBAND PHASE SIGNAL
CARRIER SIGNAL
705 RADIO SECTION
801 SIGNAL GENERATION SECTION
FIG.12
701 SIGNAL GENERATION SECTION
BASEBAND PHASE SIGNAL
704 MODULATION SECTION
CARRIER SIGNAL
705 RADIO SECTION
901 DEMODULATION SECTION
902 PHASE DISTORTION COMPENSATION SECTION
FIG.13
701 SIGNAL GENERATION SECTION
BASEBAND PHASE SIGNAL
BASEBAND AMPLITUDE
702 STORAGE SECTION
703 PHASE DISTORTION COMPENSATION SECTION
704 MODULATION SECTION
CARRIER SIGNAL
1001 AMPLITUDE CONTROL SECTION
1002 RADIO SECTION
1003 POWER AMPLIFIER
AMPLITUDE CONTROL VOLTAGE
FIG.14
MAGNITUDE OF FREQUENCY CHANGE

**Claims**

1. A modulation apparatus comprising:

   a modulator that modulates a baseband signal and generates a modulated signal; and
   a compensator that before hand compensates a baseband signal prior to modulation for a phase distortion between the baseband signal prior to modulation in the modulator and a modulation-processed baseband signal subjected to modulation in the modulator, based on a phase variation amount between adjacent data of the baseband signal and a predetermined constant.

2. The modulation apparatus according to claim 1, wherein the compensator transforms the phase variation amount into a frequency variation amount at predetermined time, and beforehand compensates the baseband signal prior to modulation for a phase distortion between the a baseband signal prior to modulation in the modulator and the modulation-processed baseband signal subjected to modulation in the modulator, based on the frequency variation amount and the constant.

3. The modulation apparatus according to claim 2, further comprising a storage that stores the constant obtained by dividing the phase distortion by the frequency variation amount,
   wherein the compensator obtains the phase distortion by multiplying the frequency variation amount by the constant stored in the storage, while beforehand compensating the baseband signal prior to modulation for the obtained phase distortion.

**4.** The modulation apparatus according to claim 2, further comprising a storage that has a table storing phase distortion selection information that associates the frequency variation amount with the constant,

wherein the compensator obtains the phase distortion by multiplying the constant selected by referring to the phase distortion selection information using the frequency variation amount by the frequency variation amount, while beforehand compensating the baseband signal prior to modulation for the obtained phase distortion.

**5.** The modulation apparatus according to claim 2, further comprising: a demodulator that demodulates the baseband signal modulated by the modulator and generates the modulation-processed baseband signal;

wherein the compensator obtains the constant by dividing a phase distortion between the baseband signal prior to modulation and the modulation-processed baseband signal demodulated in the demodulator by the phase variation amount, while beforehand compensating the baseband signal prior to modulation for the phase distortion obtained by multiplying the obtained constant by the frequency variation amount.

**6.** The modulation apparatus according to claim 5, wherein the demodulator demodulates the modulated baseband signal and generates the modulation-processed baseband signal, while demodulating a received signal.

**7.** The modulation apparatus according to claim 1, further comprising:

a phase comparator that obtains a phase distortion between a phase of the modulation-processed baseband signal and a phase of a reference signal;
a power control oscillator that generates as a modulated output signal a signal an oscillation frequency determined by a control signal that is a signal indicating the phase distortion obtained in the phase comparator; and
a frequency converter that converts a frequency of the modulated output signal generated in the voltage control oscillator into a frequency of a signal as a reference,

wherein the modulator modulates the modulation-processed baseband signal subjected to frequency-conversion in the frequency converter using the baseband signal prior to modulation compensated in the compensator, and thereby generates the modulated signal.

**8.** The modulation apparatus according to claim 1, wherein the modulator modulates a carrier signal using the baseband signal prior to modulation compensated in the compensator, and thereby generates the modulated signal.

**9.** The modulation apparatus according to claim 1, further comprising a power amplifier that amplifies the modulated signal to output as a signal to transmit from an antenna while controlling an amplitude of the modulated signal so that power is a target value.

**10.** A communication apparatus having a modulation apparatus, wherein the modulation apparatus comprises:

a modulator that modulates a baseband signal and generates a modulated signal; and
a compensator that beforehand compensates a baseband signal prior to modulation for a phase distortion between the baseband signal prior to modulation in the modulator and a modulation-processed baseband signal subjected to modulation in the modulator, based on a phase variation amount between adjacent data of the baseband signal and a predetermined constant.

**11.** A modulation method comprising: modulating a baseband signal and generating a modulated signal;

obtaining a phase distortion between a non-modulated baseband signal that is a baseband signal prior to modulation and a modulation-processed baseband signal that is a baseband signal subjected to modulation by multiplying a phase variation amount between adjacent data of the baseband signal by a stored predetermined constant; and
beforehand compensating the baseband signal prior to modulation for the obtained phase distortion.

PRIOR ART

FIG.1

EP 1 672 860 A1

PRIOR ART

FIG.2

ORTHOGONAL
BASEBAND
SIGNALS

I

Q

~60

66

NON-LINEAR
DISTORTION
COMPENSATION
SECTION

67

68
D/A

69

70
LPF

71

72
QUADRATURE
MODULATION
SECTION

73

74

MODULATED
SIGNAL

D/A

LPF

65

64

62
POWER
CALCULATION
SECTION

REFERENCE
TABLE

63

PRIOR ART

FIG.3

FIG.4

EP 1 672 860 A1

FIG.5

FIG.6

EP 1 672 860 A1

EP 1 672 860 A1

400

109

403

| 401 | 402 | 107 | 108 |

REFERENCE SIGNAL →

MODULATION SECTION

PHASE COMPARING SECTION

LPF

VCO

103

102

STORAGE SECTION

PHASE ERROR COMPENSATION SECTION

104

FREQUENCY CONVERSION SECTION

BASEBAND PHASE SIGNAL

101

SIGNAL GENERATION SECTION

FIG.7

500

109

503

| 106 | 107 | 108 |
|---|---|---|

REFERENCE SIGNAL → PHASE COMPARING SECTION → LPF → VCO

105

104

MODULATION SECTION ← FREQUENCY CONVERSION SECTION

101

BASEBAND PHASE SIGNAL

502

501

SIGNAL GENERATION SECTION → PHASE ERROR COMPENSATION SECTION ← DEMODULATION SECTION

FIG.8

FIG.9

FIG.10

EP 1 672 860 A1

FIG.11

900

903

706

701

BASEBAND
PHASE SIGNAL

902

704

705

| SIGNAL GENERATION SECTION | | PHASE ERROR COMPENSATION SECTION | | MODULATION SECTION | | RADIO SECTION |

CARRIER
SIGNAL

901

DEMODULATION
SECTION

FIG.12

FIG.13

| MAGNITUDE OF FREQUENCY CHANGE | $\alpha$ |
|---|---|
| $0 < F \leqq 10$ | 0.1 |
| $10 < F \leqq 20$ | 0.2 |
| $20 < F \leqq 30$ | 0.3 |
| ⋮ | ⋮ |

FIG.14

## INTERNATIONAL SEARCH REPORT

| International application No. |
| --- |
| PCT/JP2004/015629 |

**A. CLASSIFICATION OF SUBJECT MATTER**
Int.Cl⁷ H04L27/36, H04L27/20

According to International Patent Classification (IPC) or to both national classification and IPC

**B. FIELDS SEARCHED**

Minimum documentation searched (classification system followed by classification symbols)
Int.Cl⁷ H04L27/00-27/38

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2002-527921 A (Telefon AB. LM Ericsson), 27 August, 2002 (27.08.02), Full text; all drawings & WO 2000/021191 A & US 6101224 A1 & EP 1119902 A & DE 69910599 T & AU 1304800 A & AT 247876 T & CN 1130817 B | 1-11 |
| A | JP 6-224956 A (Toshiba Corp.), 12 August, 1994 (12.08.94), Full text; all drawings (Family: none) | 1-11 |
| A | JP 5-252219 A (Fujitsu Ltd.), 28 September, 1993 (28.09.93), Par. No. [0018] (Family: none) | 1-11 |

☐ Further documents are listed in the continuation of Box C.  ☐ See patent family annex.

| | |
| --- | --- |
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 14 January, 2005 (14.01.05) | 01 February, 2005 (01.02.05) |

| Name and mailing address of the ISA/ | Authorized officer |
| --- | --- |
| Japanese Patent Office | |
| Facsimile No. | Telephone No. |

Form PCT/ISA/210 (second sheet) (January 2004)